# EUROPÄISCHE PATENTSCHRIFT

(11) **EP 4 244 985 B1**
(45) Veröffentlichungstag und Bekanntmachung des Hinweises auf die Patenterteilung: **08.01.2025**
(21) Anmeldenummer: 21783445.6
(22) Anmeldetag: 23.09.2021
(51) Int. Cl.: H03K 17/96

(54) **VERFAHREN ZUM BETREIBEN EINES OPTOELEKTRONISCHEN TAST- BZW. BEDIENELEMENTS**
METHOD FOR OPERATING AN OPTOELECTRONIC TOUCH AND/OR OPERATING ELEMENT
PROCÉDÉ DE FONCTIONNEMENT D'UN ÉLÉMENT TACTILE ET/OU D'ACTIONNEMENT OPTOÉLECTRONIQUE

(30) Priorität: 13.11.2020 DE 102020130095
(43) Veröffentlichungstag der Anmeldung: 20.09.2023
(73) Patentinhaber: Endress+Hauser SE+Co. KG, 79689 Maulburg (DE)
(72) Erfinder: GERWIG, Simon, 79650 Schopfheim (DE); FRANK, Mike, 79541 Lörrach (DE); RAPP, Dirk, 79585 Steinen (DE)
(74) Vertreter: Laufer, Michael
(86) Internationale Anmeldenummer: PCT/EP2021/076268
(87) Internationale Veröffentlichungsnummer: WO 2022/100918

(56) Entgegenhaltungen:
- EP-A1- 2 955 850
- DE-A1- 102015 003 771
- US-A1- 2013 182 246

## Beschreibung

Die Erfindung bezieht sich auf ein Verfahren zum Betreiben zumindest eines hinter einer optisch transparenten Bedienplatte eines Feldgerätes der Automatisierungstechnik angeordneten optoelektronischen Tast- bzw. Bedienelements zur Erkennung einer Betätigung des optoelektronischen Tast- bzw. Bedienelements durch einen Bediener des Feldgerätes.

In der Prozess- ebenso wie in der Automatisierungstechnik werden vielfach Feldgeräte eingesetzt, die zur Erfassung und/oder Beeinflussung von Prozessgrößen dienen. Zur Erfassung von Prozessgrößen dienen Messgeräte, wie beispielsweise Füllstandmessgeräte, Durchflussmessgeräte, Druck- und Temperaturmessgeräte, pH-Messgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Zur Beeinflussung der Prozessgrößen werden Aktoren verwendet, wie Ventile oder Pumpen, über die z.B. der Durchfluss einer Flüssigkeit in einer Rohrleitung oder der Füllstand eines Mediums in einem Behälter geändert wird. Als Feldgeräte werden im Prinzip alle Geräte bezeichnet, die prozessnah eingesetzt werden und die prozessrelevanten Informationen liefern oder verarbeiten.

Ein optoelektronisches Bedienelement kann als Ersatz für mechanisch betätigte Tasten, Schalter, Hebel und andere Bedienelemente eingesetzt werden. Allerdings ist aufgrund der Vielzahl von Einsatzzwecken der Feldgeräte es schwierig eine sichere Erkennung eines "Tastendrucks" an einem solchen optoelektronischen Bedienelements zu ermöglichen. Erschwert wird dies zudem ferner dadurch, dass die Bedienplatte aus unterschiedlichen Materialien ausgebildet sein kann. Beispielsweise können für den Einsatz in einem explosionsgefährdeten Bereich Glas-Bedienplatten verwendet werden, wohingegen bei Feldgeräten, die nicht für den Einsatz in einem explosionsgefährdeten Bereich konzipiert sind, Kunststoff-Bedienplatten zum Einsatz kommen. Da die Bedienplatten üblicherweise in den Feldgerätedeckel eingelassen sind und der Deckel bei Feldgeräten auch getauscht werden kann, kann nicht zwangsläufig davon ausgegangen werden, dass ein und der selbe Deckel während des gesamten Lebenszyklus bei diesem verbleibt. Ebenfalls kann durch Umgebungseinflüsse bzw. Umgebungsbedingungen, wie z.B. Intensität der Sonnenstrahlung, oder auch durch Kratzer, Verschmutzung, die zuverlässige Erkennung eines "Tastendrucks" erschwert werden.

Aus dem Stand der Technik sind die EP 2 955 850 A1, die DE 10 2015 003771 und die US 2013/182246 bekannt geworden. Die EP 2 955 850 A1 offenbart einen optischen Schalter, ein Feldgerät der Automatisierungstechnik sowie ein Verfahren zum Steuern eines optischen Schalters. Die DE 10 2015 003771 offenbart ein Verfahren zum Steuern einer mit Sensorkomponenten ausgestatteten elektronischen Einrichtung und damit assoziierte Vorrichtung. Die US 2013/182246 offenbart ein Sensor bzw. System zur Erkennung von Gesten.

Der Erfindung liegt somit die Aufgabe zugrunde, ein sicheres Erkennen eines "Tastendrucks" bei einem optoelektronischen Bedienelements hinter einer Bedienplatte eines Feldgerätes der Automatisierungstechnik zu ermöglichen.

Die Aufgabe wird erfindungsgemäß gelöst durch das Verfahren gemäß Patentanspruch 1 und das Feldgerät der Automatisierungstechnik gemäß Patentanspruch 13.

Das erfindungsgemäße Verfahren zum Betreiben zumindest eines hinter einer optisch transparenten Bedienplatte eines Feldgerätes der Automatisierungstechnik angeordneten optoelektronischen Tast- bzw. Bedienelements zur Erkennung einer Betätigung des optoelektronischen Tast- bzw. Bedienelements durch einen Bediener des Feldgerätes, sieht die Folgenden Verfahrensschritte vor:
a.) Erkennen, ob sich das Feldgerät der Automatisierungstechnik in einem Innenbereich oder einem Außenbereich befindet;
b.) Festlegen einer Auswertebedingung die zur Erkennung der Betätigung des optischen Tast- bzw. Bedienelements herangezogen wird, wobei in dem Fall, dass erkannt wird, dass das Feldgerät sich in dem Innenbereich befindet, eine erste Auswertebedingung und in dem Fall, dass erkannt wird, dass das Feldgerät sich in dem Außenbereich befindet, eine von der ersten unterschiedliche zweite Auswertebedingung herangezogen wird;
c.) Erkennen bzw. Auswerten, ob eine Betätigung des optoelektronischen Tast- bzw. Bedienelements basierend auf der festgelegten Auswertebedingung vorliegt, wobei bei der ersten Auswertebedingung ein vom zeitlichen Verlauf eines von dem optoelektronischen Tast- bzw. Bedienelement stammenden Ausgangssignals abhängiger Wert in Bezug zu einem aktuellen Wert des Ausgangssignals zur Erkennung der Betätigung des optoelektronischen Tast- bzw. Bedienelements und bei der zweiten Auswertebedingung ein, insbesondere im Messbetrieb des Feldgerätes, vom zeitlichen Verlauf des Ausgangssignals unabhängiger Wert in Bezug zu einem aktuellen Wert des Ausgangssignals zur Erkennung der Betätigung des optoelektronischen Tast- bzw. Bedienelements gesetzt wird.

Eine vorteilhafte Ausführungsform des erfindungsgemäßen Verfahrens sieht vor, dass zur Erkennung einer Betätigung des optoelektronischen Tast- bzw. Bedienelements basierend auf der ersten Auswertebedingung eine Betätigung erkannt wird, wenn der aktuelle Wert des Ausgangssignal größer als ein den zeitlichen Verlauf des Ausgangssignal repräsentierender Wert ist.

Eine weitere vorteilhafte Ausführungsform des erfindungsgemäßen Verfahrens sieht vor, dass bei der zweiten Auswertebedingung ferner ein eine Umgebungsbedingung repräsentierender Wert, insb. ein eine elektromagnetische Umgebungsstrahlung repräsentierender Wert in Bezug zu einem aktuellen Wert des Ausgangssignals gesetzt wird. Insbesondere kann die Ausführungsform vorsehen, dass zur Erkennung einer Betätigung des optoelektronischen Tast- bzw. Bedienelements basierend auf der zweiten Auswertebedingung eine Betätigung erkannt wird, wenn eine Differenz aus dem aktuellen Wert des Ausgangssignals und den Umgebungsbedingung repräsentierenden Wert größer als der vom zeitlichen Verlauf des Ausgangssignals unabhängige Wert ist.

Eine weitere vorteilhafte Ausführungsform des erfindungsgemäßen Verfahrens sieht vor, dass vor dem Erkennen bzw. Auswerten, ob eine Betätigung des optoelektronischen Tast- bzw. Bedienelements vorliegt, zunächst ermittelt wird, aus welchem Material die Bedienplatte ausgebildet ist, und das Erkennen bzw. Auswerten, ob eine Betätigung des optoelektronischen Tast- bzw. Bedienelements in Abhängigkeit des Materials der Bedienplatte erfolgt. Insbesondere kann die Ausführungsform vorsehen, dass in Abhängigkeit des ermittelten Materials der Bedienplatte ein Bedienplattenmaterial abhängiger Wert beim Erkennen bzw. Auswerten, ob eine Betätigung des optoelektronischen Tast- bzw. Bedienelements herangezogen wird.

Eine weitere vorteilhafte Ausführungsform des erfindungsgemäßen Verfahrens sieht vor, dass als der vom zeitlichen Verlauf des Ausgangssignals unabhängige Wert ein Abgleichwert dient, der während der Herstellung bzw. Fertigung des Feldgerätes, vorzugsweise für jedes optoelektronische Tast- bzw. Bedienelement individuell, aufgenommen und hinterleget wird. Hierzu kann beispielsweise in der Fertigung ein Nachbau eines einen Kunststoff oder Glas aufweisenden Feldgerätedeckels verwendet werden.

Eine weitere vorteilhafte Ausführungsform des erfindungsgemäßen Verfahrens sieht vor, dass der als vom zeitlichen Verlauf des Ausgangssignals unabhängige Wert dienende Abgleichwert während des Messbetriebes des Feldgerätes angepasst wird. Insbesondere sieht die Ausführungsform vor, dass die Anpassung derartig durchgeführt wird, dass zunächst im Messbetrieb des Feldgerätes ermittelt wird, ob ein Zustand gegeben ist, der eine Anpassung zulässt, und erst wenn ein derartiger Zustand gegeben ist, die Anpassung durchgeführt wird.

Eine weitere vorteilhafte Ausführungsform des erfindungsgemäßen Verfahrens sieht vor, dass zum Ermitteln, ob ein Zustand gegeben ist, der eine Anpassung zulässt, der die Umgebungsbedingung repräsentierende Wert, insb. der die elektromagnetische Umgebungsstrahlung repräsentierende Wert herangezogen wird.

Eine weitere vorteilhafte Ausführungsform des erfindungsgemäßen Verfahrens sieht vor, dass in dem Fall, dass ein Zustand gegeben ist, der eine Anpassung zulässt, der Abgleichwert an einen aktuellen Wert des Ausgangssignals oder einen den zeitlichen Verlauf des von dem optoelektronischen Tast- bzw. Bedienelement stammenden Ausgangssignal repräsentierenden Wert angepasst wird.

Die Erfindung betrifft weiterhin ein Feldgeräte der Automatisierungstechnik zumindest aufweisend:
- eine, vorzugsweise transparente Bedienplatte, die an einer Außenseite eines Gehäuses des Feldgerätes eine Berührfläche zur Betätigung durch einen Benutzer aufweist;
- zumindest ein an einer Innenseite der Bedienplatte angeordnetes optoelektronisches Tast- bzw. Bedienelement mit zumindest einer Sendeeinheit, die an einer der Außenseite abgewandten Innenseite der Bedienplatte angeordnet und dazu ausgelegt ist, ein optisches Signal in Richtung der Bedienplatte auszusenden und mit zumindest einer zu der mindestens einen Sendeeinheit korrespondierende Empfangseinheit zum Empfangen des optischen Signals, wobei die Empfangseinheit an der Innenseite der Bedienplatte derartig angeordnet ist, dass ein an der Bedienplatte durch einen Finger des Benutzers oder einem anderen Streuobjekt gestreutes optisches Signal zumindest teilweise zu der mindestens einen Empfangseinheit gelangt, wobei das optoelektronisches Tast- bzw. Bedienelement ferner dazu eingerichtet ist, anhand des empfangenen optischen Signals die Intensität des auf die Empfangseinheit einfallenden optischen Signals zu detektiert und ein davon abhängiges Ausgangssignal bereitzustellen;
- eine Auswerteeinheit, die dazu eingerichtet ist zumindest die Verfahrensschritte a) bis c) gemäß dem erfindungsgemäßen Verfahren auszuführen.

Eine vorteilhafte Ausgestaltung des erfindungsgemäßen Feldgerätes sieht ferner ein Lichtsensor bzw. Photodetektor vor, welcher dazu eingerichtet ist, einen eine Umgebungsbedingung, insb. ein eine elektromagnetische Umgebungsstrahlung repräsentierendes Signal auszugeben und wobei die Auswerteeinheit ferner dazu eingerichtet ist, anhand des Signals den die Umgebungsbedingung repräsentierenden Wert in Bezug zu einem aktuellen Wert des Ausgangssignals des optoelektronischen Tast- bzw. Bedienelements zu setzen.

Die Erfindung wird anhand der nachfolgenden Zeichnungen näher erläutert. Es zeigt:
Fig. 1: eine schematisch stark vereinfachte Ansicht eines Feldgerätes der Automatisierungstechnik, und
Fig. 2: ein Flussdiagramm des erfindungsgemäßen Verfahrens.

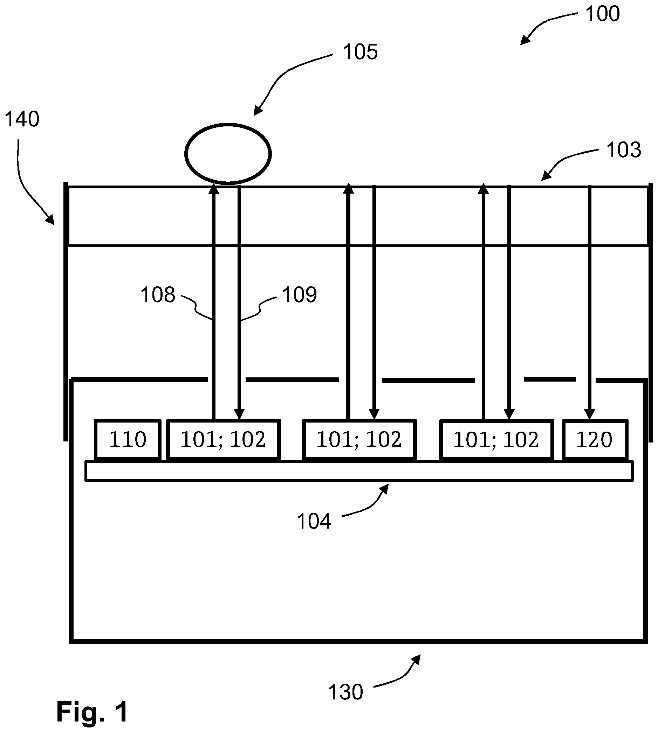

Figur 1 zeigt schematisch und stark vereinfacht ein Feldgerät der Automatisierungstechnik. Das Feldgerät besteht aus einem Feldgerätegehäuse 130 und einem daran befestigten Feldgerätedeckel 140. Die Befestigung des Deckels 140 an dem Gehäuse 130 erfolgt üblicherweise durch Aufschrauben des Deckels auf das Gehäuse. Der Deckel weist in einem Teilbereich eine optisch transparente Bedienplatte 103 auf, die die Bedienung eines dahinterliegenden optoelektronischen Tast- bzw. Bedienelements 101, 102 durch Berühren der Bedienplatte 103 mittels eines Fingers ermöglicht.

Je nach Einsatzzweck des Feldgerätes 100 ist der Feldgerätedeckel 140 und/oder die Bedienplatte 103 aus einem anderen Material gefertigt. Für einen Einsatz in einem explosionsgefährdeten Bereich beispielsweise ist die Bedienplatte 103 aus Glas gefertigt, wohingegen bei einem Einsatz außerhalb eines explosionsgefährdeten Bereichs die Bedienplatte 103 auch aus einem transparenten Kunststoff gefertigt sein kann.

Um eine Betätigung des optoelektronischen Tast- bzw. Bedienelements ("Tastendruck") zu erkennen, kann die Bedienplatte 103 von der Innenseite her optisch durch das optoelektronische Tast- bzw. Bedienelement abgetastet werden. Zur optischen Abtastung der Bedienplatte 103 ist an der Innenseite der Bedienplatte 103 zumindest ein optoelektronisches Tast- bzw. Bedienelement vorgesehen, welches zumindest aus einer Sendeeinheit 101, bspw. in Form einer Infrarotdiode, und einer Empfangseinheit 102, bspw. in Form einer Fotodiode, besteht.

Die Erfindung ist hierbei nicht auf ein einzelnes optoelektronisches Tast- bzw. Bedienelement beschränkt. Üblicherweise werden eine Reihe von optoelektronischen Tast- bzw. Bedienelementen zur Realisierung mehrerer Tasten eingesetzt. Beispielsweise können drei in Reihe angeordnete optoelektronischen Tast- bzw. Bedienelement zur Realisierung eines 3 Tasten-Bedienelementes verwendet werden. Die optoelektronischen Tast- bzw. Bedienelemente weisen jeweils eine zum Aussenden eines optischen Signals eingerichtete Sendeeinheit 101 und eine zum Empfangen des optischen Signals eingerichtete Empfangseinheit 102 auf.

Die Sendeeinheit 101 zum Aussenden des optischen Signals kann bspw. dazu eingerichtet sein, ein im infraroten Spektralbereich liegendes optisches Signal auszusenden. Dies kann bspw. durch eine Leucht- oder eine Laserdiode realisiert sein.

Die Empfangseinheit 102 zum Empfangen des optischen Signals kann bspw. eine Infrarot-Empfangsdiode, vorzugsweise eine PIN-Diode, und einen AD-Wandler, der einen von der Empfangsdiode stammenden PIN-Diodenstrom zur Weiterverarbeitung digitalisiert, aufweisen. Die Empfangseinheit 102 ist innerhalb eines Strahlungsbereichs, welcher durch das von der Sendeeinheit 101 abgestrahlte und das an der Bedienplatte 103 beim Anliegen eines Fingers diffus gestreuten Lichts 109 festgelegt ist, angeordnet.

Sowohl die Sendeeinheit 101 als auch die Empfangseinheit 102 können auf einer Leiterplatte 104 angeordnet sein. Die Empfangseinheit 102 ist derartig an der Bedienplatte 103 angeordnet, dass in dem Fall, dass ein Finger 105 eines Benutzers oder ein anderes Streuobjekt die Bedienplatte 103 in dem Bedienfeldbereich berührt oder dieser zumindest sehr nahe kommt, das gestreute optische Signal 109 zumindest teilweise zu der Empfangseinheit 102 gelangt.

Die Sendeeinheit und die Empfangseinheit 101, 102 bilden zusammen ein erstes Sende-/Empfangspaar mit Hilfe dessen ein erster Bedienfeldbereich abtastbar ist, so dass eine erste optische Taste entsteht. Das optoelektronische Bedienelement kann auch mehrere optische Tasten aufweisen, die nebeneinander und/oder übereinander in Form eines Bedienfeldes angeordnet sind. Jede optische Taste wird durch jeweils ein weiteres Sende-/Empfangspaar gebildet, welches das entsprechende weitere Bedienfeld abtastet. Somit kann das optoelektronische Bedienelement eine Vielzahl von Sende-/Empfangseinheiten aufweisen, welche im Prinzip analog wie das zuvor beschriebene Sende-/Empfangspaar arbeiten.

Wenn der Benutzer die Bedienplatte 103 oberhalb der Sendeeinheit 101 in dem dafür vorgesehenen Bedienfeldbereich mit dem Finger 105 berührt, wird das von der Sendeeinheit 101 abgestrahlte optische Signal 108 am Finger 105 diffus gestreut. Der Finger 105 wirkt in diesem Fall als Streukörper. Wenn die Bedienplatte 103 an der entsprechenden Stelle berührt wird, gelangt ein Teil des durch die Sendeeinheit 101 emittierten optischen Signals 108 zur Empfangseinheit 102. Dies ist in Fig. 1 durch den Pfeil 109 dargestellt. Die Empfangseinheit 102 detektiert die Intensität des auf sie einfallenden optischen Signals und erzeugt ein davon abhängiges Ausgangssignal.

Ferner weist das Feldgerät eine Auswerteeinheit 110 auf, welche sich bspw. auch auf der Leiterplatte 104 befinden kann. Die Auswerteinheit kann gleichwohl aber auch als ein Teil des optoelektronisches Tast- bzw. Bedienelements ausgebildet sein, d.h. in diesem integriert sein.

Ergänzend kann das Feldgerät einen Lichtsensor bzw. Photodetektor 120 aufweisen, welcher dazu eingerichtet ist, einen eine Umgebungsbedingung, insb. ein eine elektromagnetische Umgebungsstrahlung repräsentierendes Signal auszugeben, sodass eine Intensität des Umgebungslichts detektiert werden kann.

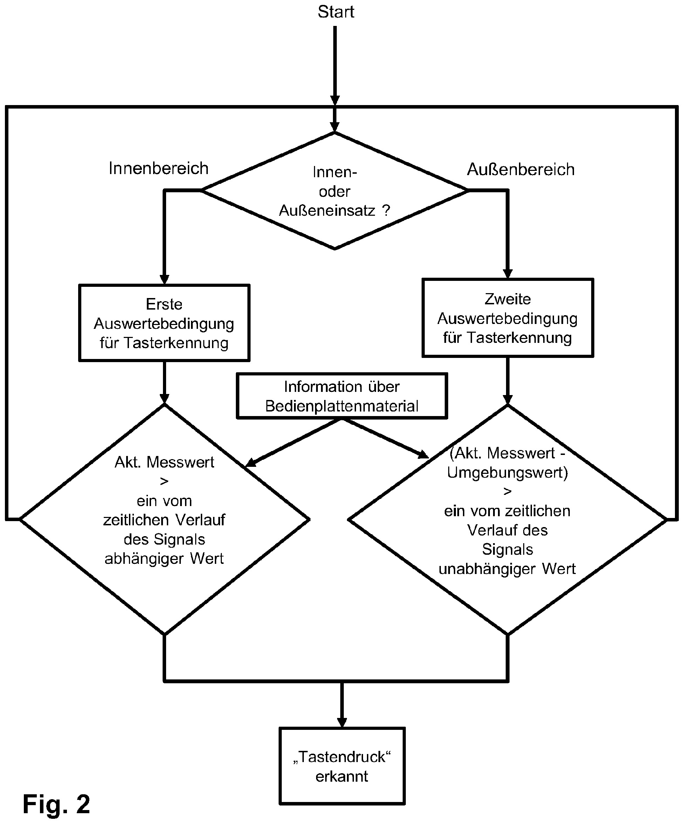

Die Auswerteeinheit ist dazu eingerichtet, das erfindungsgemäße Verfahren auszuführen. Fig. 2 zeigt zur Verdeutlichung ein Flussdiagramm des Verfahrens.

In einem ersten Verfahrensschritt wird erkannt, ob sich das Feldgerät der Automatisierungstechnik in einem Innenbereich oder einem Außenbereich einer Automatisierungstechnik befindet. Hierzu kann die Auswerteeinheit 110 auf das von dem Photodetektor 120 stammenden die Umgebungsbedingung repräsentierende Signal zurückgreifen. Beispielsweise kann bei Überschreiten eines Wertes des Signals durch die Auswerteeinheit festgestellt werden, dass das Feldgerät sich in einem Außenbereich befindet.

In einem zweiten Verfahrensschritt kann eine Auswertebedingung, die zur Erkennung der Betätigung des optischen Tast- bzw. Bedienelements herangezogen wird, in Abhängigkeit davon, wo sich das Feldgerät 100 befindet, durch die Auswerteeinheit 110 festgelegt werden. In dem Fall, dass erkannt wurde, dass das Feldgerät 100 sich in einem Innenbereich befindet, kann die Auswerteeinheit 110 dazu eingerichtet sein, eine erste Auswertebedingung und in dem Fall, dass erkannt wurde, dass das Feldgerät sich in einem Außenbereich befindet, kann die Auswerteinheit 110 dazu eingerichtet sein, eine von der ersten unterschiedliche zweite Auswertebedingung für das Erkennen eines "Tastendruckes" heranzuziehen.

In einem dritten optionalen Verfahrensschritt kann ermittelt werden, aus welchem Material die Bedienplatte 103 ausgebildet ist. Dies kann beispielsweise dadurch erfolgen, dass auf eine Information zu dem Material der Bedienplatte 103 zurückgegriffen wird. Die Information zu dem Material kann bspw. in einem nicht flüchtigen Speicher, der in dem Feldgerätgehäuse 130 oder dem Feldgerätedeckel 140 angeordnet ist, hinterlegt sein. Die Information kann bspw. seitens des Feldgeräteherstellers während der Fertigung des Feldgerätes 100 hinterlegt worden sein, sodass sie bedarfsabhängig, bspw. durch die Auswerteeinheit 110 abgefragt werden kann.

In einem vierten Verfahrensschritt wird durch die Auswerteeinheit 110 erkannt bzw. ausgewertet, ob eine Betätigung des optoelektronischen Tast- bzw. Bedienelements 101, 102 basierend auf der im zweiten Verfahrensschritt festgelegten Auswertebedingung vorliegt.

Hierzu wird bei der ersten Auswertebedingung ein vom zeitlichen Verlauf des von dem optoelektronischen Tast- bzw. Bedienelement stammenden Ausgangssignals abhängiger Wert in Bezug zu einem aktuellen Wert des Ausgangssignals gesetzt. Beispielsweise kann ein Mittelwert aus den Werten des zeitlichen Verlaufs des von dem optoelektronischen Tast- bzw. Bedienelement 101, 102 stammenden Ausgangssignals gebildet werden. Alternativ kann auch ein gleitender Mittelwert aus den Werten des zeitlichen Verlaufs des von dem optoelektronischen Tast- bzw. Bedienelement stammenden Ausgangssignals gebildet werden. Dieser Wert wird gemäß der zweiten Auswertebedingung anschließend mit einem aktuellen Wert des Ausgangssignals verglichen und in dem Fall, dass der aktuelle Wert des Ausgangssignals größer oder auch größer gleich als der den zeitlichen Verlauf repräsentierende Wert ist, wird ein "Tastendruck" erkannt und in dem Fall, dass der aktuelle Wert des Ausgangssignal niedriger ist, wird kein "Tastendruck" erkannt.

Hingegen wird bei der zweiten Auswertebedingung ein, insbesondere im eigentlichen Messbetrieb des Feldgerätes, vom zeitlichen Verlauf des Ausgangssignals unabhängiger Wert in Bezug zu einem aktuellen Wert des Ausgangssignals zur Erkennung des "Tastendrucks" gesetzt. Beispielsweise kann ein Abgleichwert, welcher während der Fertigung bzw. Herstellung des Feldgerätes beim Feldgerätehersteller, erzeugt wird, als vom zeitlichen Verlauf des Ausgangssignals unabhängiger Wert dienen. Ein derartiger Wert kann bspw. für jedes optoelektronisches Tast- bzw. Bedienelement individuell erzeugt worden sein. Um während des Messbetriebes auf den bzw. die während der Fertigung bzw. Herstellung erzeugten Abgleichwerte zugreifen zu können, kann dieser bzw. diese in einem nicht flüchtigen Speicher des Feldgeräts abgelegt sein.

Ergänzend kann vorgesehen sein, dass der nicht im eigentlichen Messbetrieb erzeugte Abgleichwert während des eigentlichen Messbetriebs angepasst, d.h. verändert wird. Hierbei kann, bspw. die Auswerteeinheit dazu eingerichtet sein, zunächst im eigentlichen Messbetrieb zu überprüfen, ob aktuell ein Zustand gegeben ist, der eine Anpassung des Abgleichwerts zulässt. Dies kann unter Heranziehung des die Umgebungsbedingung, insb. des die elektromagnetische Umgebungsstrahlung repräsentierenden Signals erfolgen. Beispielsweise kann über den zeitlichen Verlauf des Signals ermittelt werden, ob gerade keine Veränderung der Umgebung, z.B. von hell zu dunkel oder auch von Tag zu Nacht, stattfindet, umso einen zum Anpassen des Abgleichwerts geeigneten Zustand bzw. Zeitraum zu bestimmen. Insbesondere Zeiträume, in denen eine geringe Umgebungsstrahlung vorliegt, also bspw. während der Nacht, sind zum Anpassen des Abgleichwerts geeignet. Beispielsweise kann, wenn eine Änderung des Signals über einen definierten Zeitraum nicht größer ist als einen vorgebaren Maximalwert, ein Zustand, der eine Anpassung zulässt, erkannt werden. Der definierte Zeitraum kann beispielsweise größer 60 Minuten, insbesondere größer 120 Minuten sein. Nachdem ein Zustand, der eine Anpassung zulässt, ermittelt wurde, wird anschließend die eigentliche Anpassung des Abgleichwerts durchgeführt. Hierzu wird der Abgleichwert an einen aktuellen Wert des Ausgangssignals angepasst. Alternativ können auch mehrere Werte des zeitlichen Verlaufs des Ausgangssignal zu einem den zeitlichen Verlauf repräsentierenden Wert zusammengefasst werden. Beispielsweise kann eine Mittelwertbildung über mehrere Werte des Ausgangssignals gebildet werden und der Abgleichwert an diesen Wert angeglichen werden. Ferner kann vorgesehen sein, dass das Anpassen des Abgleichwerts nur in einem vorbestimmten Bereich erfolgt, d.h. der Abgleichwert kann nur plus minus eines vorgegebenen Abgleichwertbereichs angepasst werden und nicht darüber hinaus. Eine derartige Anpassung bietet den Vorteil, dass bspw. eine Alterung des optoelektronischen Tast- bzw. Bedienelements und/oder Veränderungen der Bedienplatte, z.B. Kratzer oder ähnliches, in einem gewissen Maße ausgeglichen werden können.

## Patentansprüche

1. Verfahren zum Betreiben zumindest eines hinter einer optisch transparenten Bedienplatte (103) eines Feldgerätes der Automatisierungstechnik (100) angeordneten optoelektronischen Tast- bzw. Bedienelements (101, 102) zur Erkennung einer Betätigung des optoelektronischen Tast- bzw. Bedienelements durch einen Bediener des Feldgerätes (100), **dadurch gekennzeichnet, dass** das Verfahren die Folgenden Verfahrensschritte aufweist:
a.) Erkennen, ob sich das Feldgerät der Automatisierungstechnik in einem Innenbereich oder einem Außenbereich befindet;
b.) Festlegen einer Auswertebedingung die zur Erkennung der Betätigung des optischen Tast- bzw. Bedienelements (101, 102) herangezogen wird, wobei in dem Fall, dass erkannt wird, dass das Feldgerät sich in dem Innenbereich befindet, eine erste Auswertebedingung und in dem Fall, dass erkannt wird, dass das Feldgerät (100) sich in dem Außenbereich befindet, eine von der ersten unterschiedliche zweite Auswertebedingung herangezogen wird;
c.) Erkennen bzw. Auswerten, ob eine Betätigung des optoelektronischen Tast- bzw. Bedienelements (101, 102) basierend auf der festgelegten Auswertebedingung vorliegt, wobei bei der ersten Auswertebedingung ein vom zeitlichen Verlauf eines von dem optoelektronischen Tast- bzw. Bedienelement (101, 102) stammenden Ausgangssignals abhängiger Wert in Bezug zu einem aktuellen Wert des Ausgangssignals zur Erkennung der Betätigung des optoelektronischen Tast- bzw. Bedienelements und bei der zweiten Auswertebedingung ein, insbesondere im Messbetrieb des Feldgerätes, vom zeitlichen Verlauf des Ausgangssignals unabhängiger Wert in Bezug zu einem aktuellen Wert des Ausgangssignals zur Erkennung der Betätigung des optoelektronischen Tast- bzw. Bedienelements (101, 102) gesetzt wird.

2. Verfahren nach dem vorhergehenden Anspruch, wobei zur Erkennung einer Betätigung des optoelektronischen Tast- bzw. Bedienelements (101, 102) basierend auf der ersten Auswertebedingung eine Betätigung erkannt wird, wenn der aktuelle Wert des Ausgangssignal größer als ein den zeitlichen Verlauf des Ausgangssignal repräsentierender Wert ist.

3. Verfahren nach einem oder mehreren der vorhergehenden Ansprüche, wobei bei der zweiten Auswertebedingung ferner ein eine Umgebungsbedingung repräsentierender Wert, insb. ein eine elektromagnetische Umgebungsstrahlung repräsentierender Wert in Bezug zu einem aktuellen Wert des Ausgangssignals gesetzt wird.

4. Verfahren nach dem vorhergehenden Anspruch, wobei zur Erkennung einer Betätigung des optoelektronischen Tast- bzw. Bedienelements (101, 102) basierend auf der zweiten Auswertebedingung eine Betätigung erkannt wird, wenn eine Differenz aus dem aktuellen Wert des Ausgangssignals und den Umgebungsbedingung repräsentierenden Wert größer als der vom zeitlichen Verlauf des Ausgangssignals unabhängige Wert ist.

5. Verfahren nach einem oder mehreren der vorhergehenden Ansprüche, wobei vor dem Erkennen bzw. Auswerten, ob eine Betätigung des optoelektronischen Tast- bzw. Bedienelements (101, 102) vorliegt, zunächst ermittelt wird, aus welchem Material die Bedienplatte (103) ausgebildet ist, und das Erkennen bzw. Auswerten, ob eine Betätigung des optoelektronischen Tast- bzw. Bedienelements (101, 102) in Abhängigkeit des Materials der Bedienplatte (103) erfolgt.

6. Verfahren nach dem vorhergehenden Anspruch, wobei in Abhängigkeit des ermittelten Materials der Bedienplatte (103) ein Bedienplattenmaterial abhängiger Wert beim Erkennen bzw. Auswerten, ob eine Betätigung des optoelektronischen Tast- bzw. Bedienelements (101, 102) herangezogen wird.

7. Verfahren nach einem oder mehreren der vorhergehenden Ansprüche, wobei als der vom zeitlichen Verlauf des Ausgangssignals unabhängige Wert ein Abgleichwert dient, der während der Herstellung bzw. Fertigung des Feldgerätes (100), vorzugsweise für jedes optoelektronische Tast- bzw. Bedienelement (101, 102) individuell, aufgenommen und hinterleget wird.

8. Verfahren nach einem oder mehreren der vorhergehenden Ansprüche, wobei der als vom zeitlichen Verlauf des Ausgangssignals unabhängige Wert dienende Abgleichwert während des Messbetriebes des Feldgerätes (100) angepasst wird.

9. Verfahren nach dem vorhergehenden Anspruch, wobei die Anpassung derartig durchgeführt wird, dass zunächst im Messbetrieb des Feldgerätes (100) ermittelt wird, ob ein Zustand gegeben ist, der eine Anpassung zulässt, und erst wenn ein derartiger Zustand gegeben ist, die Anpassung durchgeführt wird.

10. Verfahren nach zumindest einem der Ansprüche 3 und 9, wobei zum Ermitteln, ob ein Zustand gegeben ist, der eine Anpassung zulässt, der die Umgebungsbedingung repräsentierende Wert, insb. der die elektromagnetische Umgebungsstrahlung repräsentierende Wert herangezogen wird.

11. Verfahren nach zumindest einem der Ansprüche 8 bis 10, wobei, in dem Fall, dass ein Zustand gegeben ist, der eine Anpassung zulässt, der Abgleichwert an einen aktuellen Wert des Ausgangssignals oder einen den zeitlichen Verlauf des von dem optoelektronischen Tast- bzw. Bedienelement (101, 102) stammenden Ausgangssignal repräsentierenden Wert angepasst wird.

12. Feldgerät der Automatisierungstechnik, zumindest aufweisend:
- eine, vorzugsweise transparente Bedienplatte (103), die an einer Außenseite eines Feldgerätegehäuses (130) oder eines Feldgerätedeckels (14) eine Berührfläche zur Betätigung durch einen Benutzer aufweist;
- zumindest ein an einer Innenseite der Bedienplatte (103) angeordnetes optoelektronisches Tast- bzw. Bedienelement (101, 102) mit zumindest einer Sendeeinheit (101), die an einer der Außenseite abgewandten Innenseite der Bedienplatte (103) angeordnet und dazu ausgelegt ist, ein optisches Signal in Richtung der Bedienplatte (103) auszusenden und mit zumindest einer zu der mindestens einen Sendeeinheit (101) korrespondierende Empfangseinheit (102) zum Empfangen des optischen Signals, wobei die Empfangseinheit (102) an der Innenseite der Bedienplatte (103) derartig angeordnet ist, dass ein an der Bedienplatte (103) durch einen Finger des Benutzers oder einem anderen Streuobjekt (105) gestreutes optisches Signal (109) zumindest teilweise zu der mindestens einen Empfangseinheit (102) gelangt, wobei das optoelektronisches Tast- bzw. Bedienelement (101, 102) ferner dazu eingerichtet ist, anhand des empfangenen optischen Signals die Intensität des auf die Empfangseinheit (102) einfallenden optischen Signals zu detektiert und ein davon abhängiges Ausgangssignal bereitzustellen;
**dadurch gekennzeichnet, dass** das Feldgerät ferner aufweist:
- eine Auswerteeinheit (110), die dazu eingerichtet ist die Verfahrensschritte a) bis c) gemäß Anspruch 1 auszuführen.

13. Feldgerät der Automatisierungstechnik nach dem vorhergehenden Anspruch, ferner umfassend ein Lichtsensor bzw. Photodetektor (120), welcher dazu eingerichtet ist, einen eine Umgebungsbedingung, insb. ein eine elektromagnetische Umgebungsstrahlung repräsentierendes Signal auszugeben und wobei die Auswerteeinheit (110) ferner dazu eingerichtet ist, anhand des Signals den die Umgebungsbedingung repräsentierenden Wert in Bezug zu einem aktuellen Wert des Ausgangssignals des optoelektronischen Tast- bzw. Bedienelements (101, 102) zu setzen.

## Claims

1. A method for operating at least one optoelectronic probe or control element (101, 102), arranged behind an optically transparent control panel (103) of a field device from the field of automation technology (100), in order to detect an actuation of the optoelectronic probe or control element by an operator of the field device (100), **characterized in that** the method exhibits the following process steps:
a.) Detection of whether the field device from the field of automation technology is located indoors or outdoors;
b.) Specification of an evaluation condition that is applied in order to detect the actuation of the optical probe or control element (101, 102), wherein if the system detects that the field device is located indoors, a first evaluation condition is applied, and if the system detects that the field device (100) is located outdoors, a second evaluation condition that differs from the first evaluation condition is applied;
c.) Detection or evaluation of whether an actuation of the optoelectronic probe or control element (101, 102) has occurred based on the specified evaluation condition, wherein with the first evaluation condition a value is set based on the chronological course of an output signal originating from the optoelectronic probe or control element (101, 102) relative to a current value of the output signal for detection of the optoelectronic probe or control element, and wherein with the second evaluation condition a value is set that is not based, in particular during measuring operations of the field device, on the chronological course of the output signal relative to a current value of the output signal for detection of the actuation of the optoelectronic probe or control element (101, 102).

2. A method according to the preceding claim, wherein an actuation is detected based on the first evaluation condition for detection of an actuation of the optoelectronic probe or control element (101, 102) if the current value of the output signal is greater than a value that represents the chronological course of the output signal.

3. A method according to one or more of the preceding claims, wherein with the second evaluation condition a value is also set that represents an ambient condition, in particular a value that represents an ambient electromagnetic radiation relative to a current value of the output signal.

4. A method according to the preceding claim, wherein an actuation is detected based on the second evaluation condition for detection of an actuation of the optoelectronic probe or control element (101, 102) if a difference between the current value of the output signal and the value representing an ambient condition is greater than the value that is not based on the chronological course of the output signal.

5. A method according to one or more of the preceding claims, wherein prior to detection or evaluation of whether an actuation of the optoelectronic probe or control element (101, 102) has occurred, the material from which the control panel (103) is produced is first determined, as well as detection or evaluation of whether an actuation of the optoelectronic probe or control element (101, 102) has occurred based on the material of the control panel (103).

6. A method according to the preceding claim, wherein, based on the determined material of the control panel (103), a value that is based on the control panel material is applied when detecting or evaluating whether an actuation of the optoelectronic probe or control element (101, 102) has occurred.

7. A method according to one or more of the preceding claims, wherein a reference value, which is recorded and defined individually during manufacture of the field device (100), preferably for each optoelectronic probe or control element (101, 102), serves as the value that is not dependent of the chronological course of the output signal.

8. A method according to one or more of the preceding claims, wherein the reference value that serves as the value not based on the chronological course of the output signal is adjusted while the field device (100) is being used to take measurements.

9. A method according to the preceding claim, wherein the adjustment is performed in such a way that the field device (100) is first used to measure whether a condition is in place that allows an adjustment to be made and then, only when a condition of this kind is confirmed to be in place, is the adjustment actually performed.

10. A method according to at least one of the claims 3 and 9, wherein the value representing the ambient condition, in particular the value that represents the ambient electromagnetic radiation, is applied in order to determine whether a condition is in place that allows an adjustment to be made.

11. A method according to at least one of the claims 8 to 10, wherein if a condition is in place that allows an adjustment to be made, the reference value is adjusted to a current value of the output signal or to a value representing the chronological course of the output signal originating from the optoelectronic probe or control element (101, 102).

12. A field device from the field of automation technology, exhibiting at least:
• a control panel (103), preferably transparent, which exhibits a touch surface on an outer surface of a field device housing (130) or a field device cover (14) for actuation by a user;
• at least one optoelectronic probe or control element (101, 102), arranged on an inner side of the control panel (103), with at least one transmitter unit (101), which is arranged on an inner side of the control panel (103) that faces away from the outer surface, and which is configured to transmit an optical signal toward the control panel (103) and with at least one receiver unit (102) that corresponds to the at least one transmitter unit (101) for receiving the optical signal, wherein the receiver unit (102) is arranged on the inner side of the control panel (103) in such a way that an optical signal (109) on the control panel (103) which is diffused by one of the user's fingers or another stray object (105) still finds it way, at least in part, to the at least one receiver unit (102), wherein the optoelectronic probe or control element (101, 102) is also configured to detect the intensity of the optical signal received by the receiver unit (102) and to provide an output signal based on this as per the received optical signal;
**characterized in that** the field device also exhibits:
• an evaluation unit (110), which is configured to execute process steps a) to c) according to claim 1.

13. A field device from the field of automation technology according to the preceding claim, also comprising a light sensor / photodetector (120), that is configured to output a signal representing an ambient condition, in particular a signal representing an ambient electromagnetic radiation, and wherein the evaluation unit (110) is also configured to, based on the signal, set the value representing the environmental condition relative to a current value of the output signal of the optoelectronic probe or control element (101, 102).

## Revendications

1. Procédé destiné à l'exploitation d'au moins un élément tactile ou de commande optoélectronique (101, 102) disposé derrière une plaque de commande (103) optiquement transparente d'un appareil de terrain de la technique d'automatisation (100) pour la détection d'un actionnement de l'élément tactile ou de commande optoélectronique par un utilisateur de l'appareil de terrain (100), **caractérisé en ce que** le procédé comprend les étapes suivantes :
a) Détection si l'appareil de terrain de la technique d'automatisation se trouve dans une zone intérieure ou extérieure ;
b) Détermination d'une condition d'évaluation qui est utilisée pour la détection de l'actionnement de l'élément tactile ou de commande optique (101, 102), une première condition d'évaluation étant utilisée dans le cas où l'on détecte que l'appareil de terrain se trouve dans la zone intérieure et une deuxième condition d'évaluation, différente de la première, étant utilisée dans le cas où l'on détecte que l'appareil de terrain (100) se trouve dans la zone extérieure ;
c) Détection ou évaluation s'il y a un actionnement de l'élément tactile ou de commande optoélectronique (101, 102) sur la base de la condition d'évaluation définie, une valeur dépendant de l'évolution dans le temps d'un signal de sortie provenant de l'élément tactile ou de commande optoélectronique (101, 102) étant mise en relation, lors de la première condition d'évaluation, avec une valeur actuelle du signal de sortie pour la détection de l'actionnement de l'élément tactile ou de commande optoélectronique (101, 102) et une valeur indépendante de l'évolution dans le temps d'un signal de sortie étant mise en relation, lors de la deuxième condition d'évaluation, notamment en mode de mesure de l'appareil de terrain, avec une valeur actuelle du signal de sortie pour la détection de l'actionnement de l'élément tactile ou de commande optoélectronique (101, 102).

2. Procédé selon la revendication précédente, pour lequel, pour la détection d'un actionnement de l'élément tactile ou de commande optoélectronique (101, 102), un actionnement est détecté sur la base de la première condition d'évaluation, lorsque la valeur actuelle du signal de sortie est supérieure à une valeur représentant l'évolution dans le temps du signal de sortie.

3. Procédé selon l'une ou plusieurs des revendications précédentes, pour lequel, dans la deuxième condition d'évaluation, une valeur représentant une condition ambiante, notamment une valeur représentant un rayonnement électromagnétique ambiant, est en outre mise en relation avec une valeur actuelle du signal de sortie.

4. Procédé selon la revendication précédente, pour lequel, pour la détection d'un actionnement de l'élément tactile ou de commande optoélectronique (101, 102), un actionnement est reconnu sur la base de la deuxième condition d'évaluation lorsqu'une différence entre la valeur actuelle du signal de sortie et la valeur représentant la condition ambiante est supérieure à la valeur indépendante de l'évolution dans le temps du signal de sortie.

5. Procédé selon l'une ou plusieurs des revendications précédentes, pour lequel, avant de détecter ou d'évaluer s'il y a un actionnement de l'élément tactile ou de commande optoélectronique (101, 102), on détermine d'abord en quel matériau la plaque de commande (103) est réalisée, puis on détecte et on évalue si un actionnement de l'élément tactile ou de commande optoélectronique (101, 102) a lieu en fonction du matériau de la plaque de commande (103).

6. Procédé selon la revendication précédente, pour lequel, en fonction du matériau déterminé de la plaque de commande (103), une valeur dépendant du matériau de la plaque de commande est utilisée lors de la détection ou de l'évaluation si un actionnement de l'élément tactile ou de commande optoélectronique (101, 102) est utilisé.

7. Procédé selon l'une ou plusieurs des revendications précédentes, pour lequel la valeur indépendante de l'évolution dans le temps du signal de sortie est une valeur d'ajustage qui est enregistrée et stockée pendant la fabrication ou la production de l'appareil de terrain (100), de préférence individuellement pour chaque élément tactile ou de commande optoélectronique (101, 102).

8. Procédé selon l'une ou plusieurs des revendications précédentes, pour lequel la valeur d'ajustage servant de valeur indépendante de l'évolution dans le temps du signal de sortie est adaptée pendant le mode de mesure de l'appareil de terrain (100).

9. Procédé selon la revendication précédente, pour lequel l'adaptation est effectuée de telle sorte que l'on détermine d'abord, en mode de mesure de l'appareil de terrain (100), s'il existe un état qui permet une adaptation, et ce n'est que lorsqu'un tel état existe que l'adaptation est effectuée.

10. Procédé selon au moins l'une des revendications 3 et 9, pour lequel, pour déterminer s'il existe une condition permettant une adaptation, on utilise la valeur représentant la condition ambiante, notamment la valeur représentant le rayonnement électromagnétique ambiant.

11. Procédé selon au moins l'une des revendications 8 à 10, pour lequel, dans le cas où un état est donné qui permet une adaptation, la valeur d'ajustage est adaptée à une valeur actuelle du signal de sortie ou à une valeur représentant l'évolution dans le temps du signal de sortie provenant de l'élément tactile ou de commande optoélectronique (101, 102).

12. Appareil de terrain de la technique d'automatisation, lequel comprend au moins :
- une plaque de commande (103), de préférence transparente, laquelle présente sur une face extérieure d'un boîtier d'appareil de terrain (130) ou d'un couvercle d'appareil de terrain (14) une surface de contact pour l'actionnement par un utilisateur ;
- au moins un élément tactile ou de commande optoélectronique (101, 102) disposé sur une face intérieure de la plaque de commande (103) avec au moins une unité d'émission (101), laquelle est disposée sur une face intérieure opposée à la face extérieure de la plaque de commande (103) et laquelle est conçue pour émettre un signal optique en direction de la plaque de commande (103) et avec au moins une unité de réception (102) correspondant à l'au moins une unité d'émission (101), laquelle unité de réception est destinée à recevoir le signal optique, l'unité de réception (102) étant disposée sur la face intérieure de la plaque de commande (103) de telle sorte qu'un signal optique (109) diffusé sur la plaque de commande (103) par un doigt de l'utilisateur ou un autre objet diffusant (105) parvienne au moins partiellement à l'au moins une unité de réception (102), l'élément tactile ou de commande optoélectronique (101, 102) étant en outre conçu pour détecter, à l'aide du signal optique reçu, l'intensité du signal optique incident sur l'unité de réception (102) et pour fournir un signal de sortie qui en dépend ;
**caractérisé en ce que** l'appareil de terrain comprend en outre :
- une unité d'évaluation (110), laquelle est conçue pour exécuter les étapes de procédé a) à c) selon la revendication 1.

13. Appareil de terrain de la technique d'automatisation selon la revendication précédente, lequel appareil comprend en outre un détecteur de lumière ou un photodétecteur (120), lequel détecteur/photodétecteur est conçu pour émettre un signal représentant une condition ambiante, notamment un rayonnement électromagnétique ambiant, et l'unité d'évaluation (110) étant en outre conçue pour mettre en relation, à l'aide du signal, la valeur représentant la condition ambiante avec une valeur actuelle du signal de sortie de l'élément tactile ou de commande optoélectronique (101, 102).
